(19)

Europäisches Patentamt
European Patent Office
Office européen des brevets

(11) **EP 4 501 889 A1**

(12) **EUROPEAN PATENT APPLICATION**
published in accordance with Art. 153(4) EPC

(43) Date of publication:
**05.02.2025 Bulletin 2025/06**

(21) Application number: **23871710.2**

(22) Date of filing: **31.08.2023**

(51) International Patent Classification (IPC):
*C04B 35/596* (2006.01)     *C04B 35/64* (2006.01)
*F16C 33/24* (2006.01)      *F16C 33/32* (2006.01)
*H05K 1/03* (2006.01)

(52) Cooperative Patent Classification (CPC):
**C04B 35/584; C04B 35/64; F16C 33/24;
F16C 33/32; H05K 1/03**

(86) International application number:
**PCT/JP2023/031775**

(87) International publication number:
**WO 2024/070470 (04.04.2024 Gazette 2024/14)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority:  **27.09.2022   JP 2022153196**

(71) Applicants:
• **Kabushiki Kaisha Toshiba
  Tokyo 105-0023 (JP)**
• **Toshiba Materials Co., Ltd.
  Isogo-Ku
  Yokohama-Shi
  Kanagawa 235-0032 (JP)**

(72) Inventors:
• **FUKASAWA, Takayuki
  Yokohama-shi, Kanagawa 235-0032 (JP)**
• **AOKI, Katsuyuki
  Yokohama-shi, Kanagawa 235-0032 (JP)**
• **HOUTSUKI, Naoto
  Yokohama-shi, Kanagawa 235-0032 (JP)**
• **YAMAGATA, Yoshihito
  Yokohama-shi, Kanagawa 235-0032 (JP)**

(74) Representative: **Henkel & Partner mbB
Patentanwaltskanzlei, Rechtsanwaltskanzlei
Maximiliansplatz 21
80333 München (DE)**

(54) **SILICON NITRIDE SINTERED BODY, WEAR-RESISTANT MEMBER, SUBSTRATE FOR SEMICONDUCTOR DEVICES, AND METHOD FOR PRODUCING SILICON NITRIDE SINTERED BODY**

(57)     The present invention provides a silicon nitride sintered body which enables firing at low temperatures, while having high strength. A silicon nitride sintered body according to one embodiment of the present invention contains 0.1% by mass to 10% by mass of zirconium in terms of oxide. With respect to the XRD analysis ($2\theta$) of an any given cross-section of the silicon nitride sintered body, if $I_{35.3}$ is the maximum peak intensity detected at $35.3° \pm 0.2°$ on the basis of $\alpha$-form silicon nitride crystal grains, $I_{27.0}$ is the maximum peak detected at $27.0° \pm 0.2°$ on the basis of $\beta$-form silicon nitride crystal grains, and $I_{33.9}$ is the maximum peak detected at $33.9° \pm 0.2°$ on the basis of zirconium nitride, $0.01 \leq I_{35.3}/_{27.0} \leq 0.5$ and $0 \leq I_{33.9}/I_{27.0} \leq 1.0$ are satisfied.

FIG. 5

EP 4 501 889 A1

**Description**

[Technical Field]

Embodiments described below relate generally to a silicon nitride sintered body, a wear-resistant member, a substrate for semiconductor devices, and a method for producing a silicon nitride sintered body.

[Background Art]

Silicon nitride sintered bodies are used in various fields to take advantage of their high strength. For example, in International Publication No. 2020/121752 (Patent Literature 1), a silicon nitride sintered body is used in wear-resistant members such as bearing balls, etc. In International Publication No. 2020/044974 (Patent Literature 2), a silicon nitride sintered body is used in a substrate for semiconductor devices. According to Patent Literature 1, a silicon nitride sintered body having a three-point bending strength of not less than 900 MPa was obtained. According to Patent Literature 2, a silicon nitride sintered body having a three-point bending strength of not less than 700 MPa was obtained.

According to the production methods described in Patent Literature 1 and Patent Literature 2, silicon nitride sintered bodies are made by firing at high temperatures of about 1,600 to 2,000 °C. Generally, the furnace used to fire the silicon nitride sintered body is an electric furnace. In recent years, the demand for decarbonization is increasing. To reduce the amount of carbon dioxide discharged in the production of a silicon nitride sintered body, it is considered effective to reduce the firing temperature.

For example, Japanese Patent No. 5811391 (Patent Literature 3) discusses a method of using a packing powder in a firing chamber. In Patent Literature 3, the packing powder is used to suppress the effects of SiO gas and Mg gas discharged from the degreased body. However, the firing temperature is 1,550 to 1,900 °C. The firing temperature of the production method described in Patent Literature 3 is about equal to the firing temperatures described in Patent Literature 1 and Patent Literature 2.

For example, Japanese Patent No. 5062402 (Patent Literature 4) discusses the use of reaction sintering to fire at 1,300 to 1,375 °C. According to the production method described in Patent Literature 4, the firing is performed at a low temperature, but the strength of the silicon nitride sintered body obtained is about 140 MPa. With such low strength, it has been difficult to use the silicon nitride sintered body as a wear-resistant member or a substrate for semiconductor devices.

[Prior Art Documents]

[Patent Literature]

Patent Literature 1: International Publication No. 2020/121752
Patent Literature 2: International Publication No. 2020/044974
Patent Literature 3: Japanese Patent No. 5811391
Patent Literature 4: Japanese Patent No. 5062402

[Summary of Invention]

[Problem to be Solved by the Invention]

Thus, conventionally, there was no silicon nitride sintered body that could be fired at a low temperature and had high strength. Embodiments of the invention are directed to address such problems, and to provide a silicon nitride sintered body that can be fired at a low temperature and has high strength.

[Means for Solving the Problem]

A silicon nitride sintered body according to an embodiment includes not less than 0.1 mass% and not more than 10 mass% of zirconium when converted to oxide. In XRD analysis ($2\theta$) of any cross section of the silicon nitride sintered body, $0.01 \leq I_{35.3}/I_{27.0} \leq 0.5$ and $0 \leq I_{33.9}/I_{27.0} \leq 1.0$ are satisfied; $I_{35.3}$ is a maximum peak intensity detected at $35.3° \pm 0.2°$ based on $\alpha$-silicon nitride crystal grains; $I_{27.0}$ is a most intense peak detected at $27.0° \pm 0.2°$ based on $\beta$-silicon nitride crystal grains; and $I_{33.9}$ is a most intense peak detected at $33.9° \pm 0.2°$ based on zirconium nitride.

[Brief Description of Drawings]

[FIG. 1]

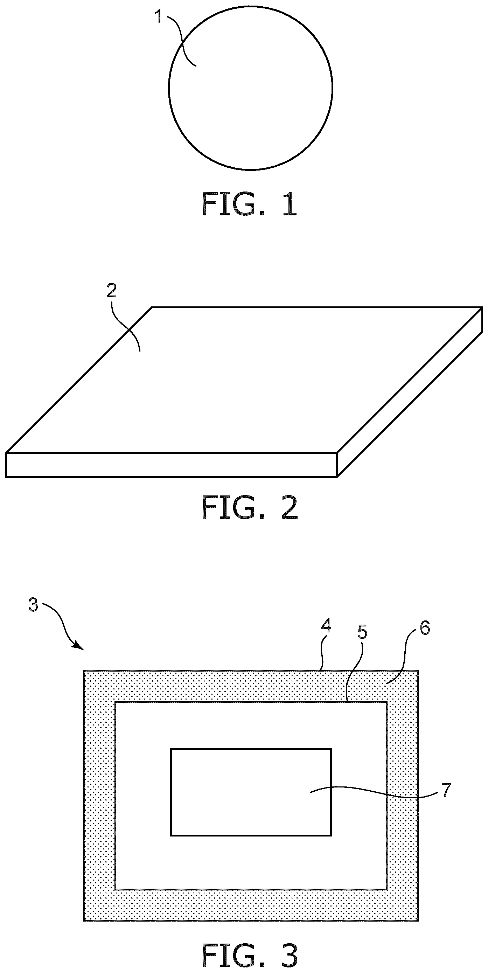

FIG. 1 is a schematic view showing a bearing ball, which is an example of a wear-resistant member.
[FIG. 2]
FIG. 2 is a schematic view showing an example of a substrate for semiconductor devices.
[FIG. 3]
FIG. 3 is a top view showing an example of a firing chamber.
[FIG. 4]

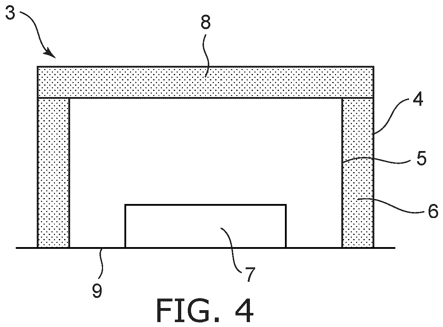

FIG. 4 is a side view showing another example of a firing chamber.
[FIG. 5]

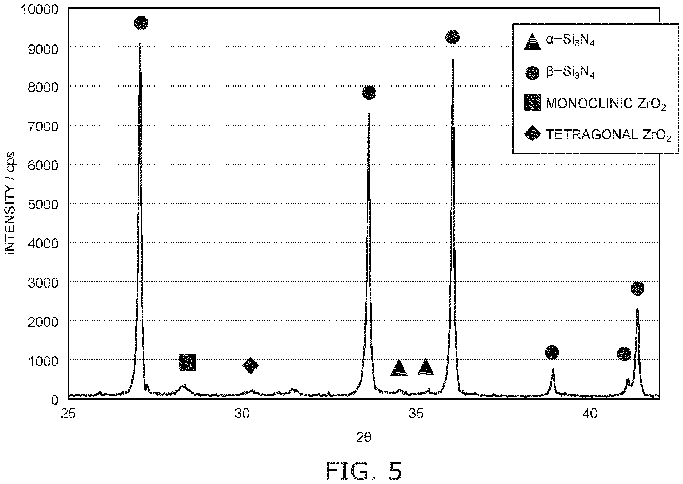

FIG. 5 is a graph showing an example of an XRD analysis result of a silicon nitride sintered body according to an embodiment.

[Detailed Description]

A silicon nitride sintered body according to an embodiment includes not less than 0.1 mass% and not more than 10 mass% of zirconium when converted to oxide. In XRD analysis ($2\theta$) of any cross section of the silicon nitride sintered body, $0.01 \le I_{35.3}/I_{27.0} \le 0.5$ and $0 \le I_{33.9}/I_{27.0} \le 1.0$ are satisfied; $I_{35.3}$ is a maximum peak intensity detected at $35.3° \pm 0.2°$ based on $\alpha$-silicon nitride crystal grains; $I_{27.0}$ is a most intense peak detected at $27.0° \pm 0.2°$ based on $\beta$-silicon nitride crystal grains; and $I_{33.9}$ is a most intense peak detected at $33.9° \pm 0.2°$ based on zirconium nitride.

A silicon nitride sintered body according to an embodiment includes not less than 0.1 mass% and not more than 10 mass% of zirconium when converted to oxide. The zirconium is converted into an oxide as $ZrO_2$. At least a portion of the zirconium (Zr) component forms a liquid phase at about 1,300 °C. Therefore, zirconium has an effect of lowering the firing temperature. Therefore, to fire at a low temperature, it is effective to include not less than 0.1 mass% and not more than 10 mass% of zirconium when converted to oxide. The effect of the addition is small when the zirconium content is less than 0.1 mass% when converted to oxide. When the zirconium content is greater than 10 mass% when converted to oxide, much zirconium nitride is formed. Also, there is a possibility that voids may become large. Therefore, the strength and/or insulative properties degrade. Accordingly, it is favorable for the zirconium content to be within the range of not less than 0.1 mass% and not more than 10 mass% when converted to oxide, and more favorably within the range of not less than 0.5 mass% and not more than 6 mass% when converted to oxide.

Also, when XRD analysis ($2\theta$) of any cross section of the silicon nitride sintered body according to the embodiment is performed, in the analysis results, $0.01 \le I_{35.3}/I_{27.0} \le 0.5$ and $0 \le I_{33.9}/I_{27.0} \le 1.0$ are satisfied; $I_{35.3}$ is a maximum peak intensity detected at $35.3° \pm 0.2°$ based on $\alpha$-silicon nitride crystal grains; $I_{27.0}$ is a maximum peak intensity detected at $27.0° \pm 0.2°$ based on $\beta$-silicon nitride crystal grains; and $I_{33.9}$ is a maximum peak intensity detected at $33.9° \pm 0.2°$ based on zirconium nitride.

First, a method of the XRD analysis ($2\theta$) will be described. In the XRD analysis, any cross section of the silicon nitride sintered body is used as the measurement surface. A cross section that has a surface roughness Ra of not more than 1 $\mu$m is used as the measurement surface. A Cu target (Cu-K$\alpha$) is used in the XRD analysis. The XRD analysis is performed by setting the tube voltage to 40 kV, the tube current to 40 mA, the scan speed to 2.0°/min, the slit (RS) to 0.15 mm, and the scanning range ($2\theta$) to 10° to 50°. Qualitative analysis or quantitative analysis that corresponds to the crystal compounds can be performed by the XRD analysis. D8 ADVANCE made by BRUKER or a device having equivalent performance is used for the measurement.

In the obtained analysis results, $I_{35.3}$ is the maximum peak intensity detected at $35.3° \pm 0.2°$ based on $\alpha$-silicon nitride crystal grains; $I_{27.0}$ is the maximum peak intensity detected at $27.0° \pm 0.2°$ based on $\beta$-silicon nitride crystal grains; and $I_{33.9}$ is the maximum peak intensity detected at $33.9° \pm 0.2°$ based on zirconium nitride.

The most intense peak refers to the peak having the largest intensity among the peaks detected within each prescribed range. The intensity of the peak top is used as the "intensity". Also, the skirt of the peak may be outside the prescribed range as long as the peak top is within the prescribed range. The peak based on $\alpha$-silicon nitride crystal grains also includes $\alpha$-sialon. The peak based on $\beta$-silicon nitride crystal grains also includes $\beta$-sialon. The presence of $\alpha$-silicon nitride crystal grains and $\beta$-silicon nitride crystal grains in the silicon nitride sintered body can be confirmed using other XRD peaks. For example, when $\alpha$-silicon nitride crystal grains are present, peaks are detected at $35.3° \pm 0.2°$ and $31.0° \pm 0.2°$. Also, when $\beta$-silicon nitride crystal grains are present, peaks are detected at $27.0° \pm 0.2°$ and $33.7° \pm 0.2°$. In other words, it is determined that $\alpha$-silicon nitride crystal grains are present in the silicon nitride sintered body when peaks are detected at $35.3° \pm 0.2°$ and $31.0° \pm 0.2°$. Similarly, it is determined that $\beta$-silicon nitride crystal grains are present in the silicon nitride sintered body when peaks are detected at $27.0° \pm 0.2°$ and $33.7° \pm 0.2°$.

If necessary, qualitative analysis is used to check the presence of zirconium nitride. When zirconium nitride is not detected by qualitative analysis or quantitative analysis, it is determined that the peak at $I_{33.9}$ is not present, that is, $I_{33.9} = 0$. For simplicity, for a silicon nitride sintered body confirmed to include zirconium by qualitative analysis or quantitative analysis, the peak that is detected at $33.9° \pm 0.2°$ may be determined to be a peak ($I_{33.9}$) based on zirconium nitride.

$0.01 \leq I_{35.3}/I_{27.0} \leq 0.5$ being satisfied means that both $\alpha$-silicon nitride crystal grains and $\beta$-silicon nitride crystal grains are present. $\alpha$-Silicon nitride crystal grains are round particles that tend to have aspect ratios of less than 2. $\beta$-Silicon nitride crystal grains tend to be slender particles having aspect ratios of not less than 2. By $\alpha$-silicon nitride crystal grains penetrating gaps between the slender $\beta$-silicon nitride crystal grains, the silicon nitride sintered body can be densified; and the strength of the silicon nitride sintered body can be increased. As a result, as described below, a high-strength silicon nitride sintered body can be obtained even in low-temperature firing having a firing temperature of less than 1,650 °C.

Silicon nitride is a major component of the silicon nitride sintered body. $I_{35.3}/I_{27.0}$ being not more than 0.5 means that $\beta$-silicon nitride crystal grains account for the greatest mass in the silicon nitride sintered body. In other words, the mass ratio of the $\beta$-silicon nitride crystal grains is greater than the mass ratio of the $\alpha$-silicon nitride crystal grains. Also, the peaks that appear in the XRD analysis are affected by the composition, the crystallinity, the amount present, the orientation, etc. Among the peaks related to the $\beta$-silicon nitride crystal grains, the likelihood of the intensity of the peak detected at $27.0° \pm 0.2°$ being a maximum is high. Also, among the peaks related to the $\alpha$-silicon nitride crystal grains, the likelihood of the peak detected at $35.3° \pm 0.2°$ being a maximum is high. The composition can be optimized by controlling the ratio of the maximum peak intensity $I_{35.3}$ based on the $\alpha$-silicon nitride crystal grains to the maximum peak intensity $I_{27.0}$ based on the $\beta$-silicon nitride crystal grains, which is the major component, and the ratio of the maximum peak intensity based on the other components to the maximum peak intensity $I_{27.0}$.

When $I_{35.3}/I_{27.0}$ is within the range of not less than 0.01 and not more than 0.5, $\alpha$-silicon nitride crystal grains are distributed in the gaps between the $\beta$-silicon nitride crystal grains. The slender $\beta$-silicon nitride crystal grains are complexly entangled, and the $\alpha$-silicon nitride crystal grains fill the gaps between the slender $\beta$-silicon nitride crystal grains, which leads to increased strength. When $I_{35.3}/I_{27.0}$ is less than 0.01, there is a possibility that the amount of the $\alpha$-silicon nitride crystal grains present may be insufficient. The gaps between the $\beta$-silicon nitride crystal grains become large, which may cause the strength of the silicon nitride sintered body to decrease. Also, voids are easily formed, and there is a possibility that the insulative properties of the silicon nitride sintered body may degrade. When $I_{35.3}/I_{27.0}$ is large and is greater than 0.5, the $\beta$-silicon nitride crystal grains become insufficient, and a configuration can no longer be made in which the slender $\beta$-silicon nitride crystal grains are complexly entangled. As a result, there is a possibility that the strength of the silicon nitride sintered body may be reduced. Accordingly, it is favorable for $I_{35.3}/I_{27.0}$ to be within the range of not less than 0.01 and not more than 0.5, and more favorably within the range of not less than 0.05 and not more than 0.4.

$I_{33.9}$ is a peak based on zirconium nitride (ZrN). When XRD analysis of the silicon nitride sintered body according to the embodiment is performed, $0 \leq I_{33.9}/I_{27.0} \leq 1.0$ is satisfied. $I_{33.9}/I_{27.0}$ being not more than 1.0 means that the amount of zirconium nitride present with respect to the $\beta$-silicon nitride crystal grains is suppressed. When $I_{33.9}/I_{27.0}$ is greater than 1.0, there is much zirconium nitride, and so the strength of the silicon nitride sintered body is reduced. Also, the insulative properties of the silicon nitride sintered body degrade because zirconium nitride is an electrically-conductive material. It is therefore favorable for $I_{33.9}/I_{27.0}$ to be within the range of not less than 0 and not more than 1.0, and more favorably to be within the range of not less than 0 and not more than 0.6. $I_{33.9}/I_{27.0} = 0$ means that ZrN is not present, or $I_{33.9}$ is not detected (is below the detection limit).

In the XRD analysis, it is favorable for $0.01 \leq I_{28.2}/I_{27.0} \leq 0.30$ to be satisfied, wherein $I_{28.2}$ is the maximum peak intensity detected at $28.2° \pm 0.2°$ based on zirconium oxide. Furthermore, it is favorable for $0.02 \leq I_{30.1}/I_{27.0} \leq 0.30$ to be satisfied, wherein $I_{30.1}$ is the maximum peak intensity detected at $30.1° \pm 0.2°$ based on zirconium oxide.

The presence of a peak based on zirconium oxide means that at least a portion of the zirconium in the silicon nitride sintered body is present as zirconium oxide. Examples of zirconium oxide include $ZrO_2$, hybrid Zr oxides, etc. For example, when aluminum oxide is used as a sintering aid, there are also cases where a Zr-Al-O compound is formed as a hybrid Zr oxide. Similarly, when magnesium oxide is used as a sintering aid, there are also cases where a Zr-Mg-O compound is formed as a hybrid Zr oxide. Hybrid Zr oxides also include partially stabilized zirconia, fully stabilized zirconia, etc. Examples of partially stabilized zirconia or fully stabilized zirconia include oxides of zirconium oxide with yttrium oxide, cerium oxide, magnesium oxide, etc., in solid solution.

Zirconium oxide has one of a monoclinic, tetragonal, or cubic crystal structure. The detection of $I_{28.2}$ or $I_{30.1}$ indicates that the zirconium oxide is monoclinic or tetragonal. Monoclinic is a crystal structure that is stable at room temperature. Tetragonal is a crystal structure that is stable at about 1,170 °C. Cubic is a crystal structure that is stable at about 2,370 °C. In the XRD analysis, the detection of a zirconium oxide peak indicates the presence of crystalline zirconium oxide. In the silicon nitride sintered body, zirconium oxide is present in the grain boundary phase. The presence of a crystal compound of zirconium oxide in the grain boundary phase can reinforce the grain boundary phase. As a result, the strength of the silicon nitride sintered body can be further improved.

$0.01 \leq I_{28.2}/I_{27.0} \leq 0.30$ or $0.02 \leq I_{30.1}/I_{27.0} \leq 0.30$ being satisfied means that the zirconium oxide is monoclinic or tetragonal. Also, $0.01 \leq I_{28.2}/I_{27.0} \leq 0.30$ and $0.02 \leq I_{30.1}/I_{27.0} \leq 0.30$ both may be satisfied, or only one may be satisfied.

Also, when only one is satisfied, it is favorable for one of the $I_{28.2}$ or $I_{30.1}$ peak not to be detected (to be below the detection limit). Also, the detection of $I_{28.2}$ indicates that the zirconium oxide is monoclinic. The detection of $I_{30.1}$ indicates that the zirconium oxide is tetragonal.

Monoclinic or tetragonal which is stable from room temperature to about 1,000 °C is used as a major part. On the other hand, cubic is stable at about 2,370 °C. Monoclinic or tetragonal being used as the major part means that a composition that is fired at a low temperature of less than 1,650 °C is stable. Much cubic present means that the heat conducted to the sintered body in the firing process is unstable. There is a possibility that this may make it impossible to control the size of the zirconium oxide and/or voids. In other words, little or no cubic zirconium oxide is favorable. Cubic zirconium oxide can be observed using a TEM (transmission electron microscope), etc.

Also, it is favorable for tetragonal zirconium oxide to be present. As described below, when zirconium oxide reacts with the sintering aid of magnesium oxide, etc., in the sintering process, zirconium oxide becomes tetragonal and is stable. In other words, the presence of tetragonal zirconium oxide indicates that the zirconium oxide and the other sintering aids have reacted and are stable. Examples of other sintering aids include components that form partially stabilized zirconia.

It is therefore favorable for $I_{28.2}/I_{27.0}$ to be within the range of not less than 0.01 and not more than 0.30, and more favorably within the range of not less than 0.05 and not more than 0.20. Also, it is favorable for $I_{30.1}/I_{27.0}$ to be within the range of not less than 0.02 and not more than 0.30, and more favorably within the range of not less than 0.05 and not more than 0.20.

Also, in the XRD analysis, it is favorable for $0 \le I_{36.7}/I_{27.0} \le 0.50$ or $0 \le I_{41.9}/I_{27.0} \le 0.50$ to be satisfied, wherein $I_{36.7}$ is the maximum peak intensity detected at $36.7° \pm 0.2°$, and $I_{41.9}$ is the maximum peak intensity detected at $41.9° \pm 0.2°$. Both $0 \le I_{36.7}/I_{27.0} \le 0.50$ and $0 \le I_{41.9}/I_{27.0} \le 0.50$ may be satisfied, or only one may be satisfied.

The peak that is detected at $36.7° \pm 0.2°$ and the peak that is detected at $41.9° \pm 0.2°$ are based on crystal compounds in the grain boundary phase. The peaks that are observed in these two ranges are based on crystal compounds other than zirconium oxide, and indicate the presence of crystal compounds other than zirconium oxide in the grain boundary phase. Examples of such crystal compounds include compounds including at least one selected from a rare-earth element, aluminum, and magnesium. Examples of the rare-earth element include yttrium and lanthanoid elements. Examples of the crystal compounds include an oxide, a nitride, or an oxynitride including an element selected from a rare-earth element, aluminum, and magnesium. Each may be a hybrid oxide, a hybrid nitride, or a hybrid oxynitride.

As described below, examples of the sintering aid include rare-earth element oxides, magnesium oxide, and aluminum oxide. Rare-earth elements and magnesium dissolve in zirconium oxide to form hybrid Zr oxides. Hybrid Zr oxides form stable phases. There are also cases where aluminum and oxygen dissolve in silicon nitride to form sialon.

$0 \le I_{36.7}/I_{27.0} \le 0.50$ or $0 \le I_{41.9}/I_{27.0} \le 0.50$ being satisfied means that the sintering aid contributes to the formation of the stable phase. That is, the amount of the crystal compounds present in the grain boundary phase is suppressed. As a result, the grain boundary phase can be reinforced by the pinning effect of the zirconium oxide particles. In other words, it is favorable for $I_{36.7}/I_{27.0}$ or $I_{41.9}/I_{27.0}$ not to be greater than 0.50. When each is greater than 0.50, much of crystal compounds other than zirconium oxide that have low pinning effects are present. It is therefore favorable for $I_{36.7}/I_{27.0}$ to be within the range of not less than 0 and not more than 0.50, and more favorably within the range of not less than 0 and not more than 0.4. It is favorable for $0 \le I_{41.9}/I_{27.0} \le 0.50$ to be within the range of not less than 0 and not more than 0.5, and more favorably within the range of not less than 0 and not more than 0.4.

Also, the strength and hardness of the silicon nitride sintered body can be improved by the presence of crystal compounds in the grain boundary phase. This is because the crystal compound phase is harder than the amorphous phase. The improvement of the strength and hardness leads to the improvement of the wear resistance. It is therefore favorable for one or more of $0 < I_{36.7}/I_{27.0} \le 0.50$, $0 < I_{41.9}/I_{27.0} \le 0.50$, $0 < I_{36.7}/I_{27.0} \le 0.50$, and $0 < I_{41.9}/I_{27.0} \le 0.50$ to be satisfied.

FIG. 5 is a graph showing an example of XRD analysis results of the silicon nitride sintered body according to the embodiment. In FIG. 5, the peaks that are marked with triangular symbols are peaks based on the $\alpha$-silicon nitride crystal grains. The peaks that are marked with round symbols are peaks based on the $\beta$-silicon nitride crystal grains. The peaks that are marked with quadrilateral symbols are peaks based on monoclinic zirconium oxide. The peaks that are marked with diamond symbols are peaks based on tetragonal zirconium oxide.

In the analysis results shown in FIG. 5, $I_{35.3}/I_{27.0}$ is within the range of not less than 0.01 and not more than 0.5; and $I_{33.9}/I_{27.0}$ is within the range of not less than 0 and not more than 1.0. $I_{30.1}/I_{27.0}$ is within the range of not less than 0.02 and not more than 0.30; and $I_{28.2}/I_{27.0}$ is within the range of not less than 0.01 and not more than 0.30. In the analysis results shown in FIG. 5, peaks are not detected in the range of $36.7° \pm 0.2°$ or the range of $41.9° \pm 0.2°$. In other words, $I_{36.7}/I_{27.0}$ and $I_{41.9}/I_{27.0}$ are zero.

Also, it is favorable for the silicon nitride sintered body to include zirconium oxide particles. For example, the zirconium oxide particles are dispersed in the grain boundary phase inside the silicon nitride sintered body. It is favorable for the average particle size of the zirconium oxide particles in a 100 $\mu$m $\times$ 100 $\mu$m measurement area in any cross section to be not less than 0.05 $\mu$m and not more than 2 $\mu$m.

As described above, it is favorable for the zirconium oxide to be a crystal compound having a prescribed XRD peak. The particle sizes of the zirconium oxide particles are the sizes of particles of zirconium oxide. The zirconium oxide particles may be either single-crystal bodies or polycrystals. It is favorable for the average particle size of the zirconium oxide particles to be within the range of not less than 0.05 $\mu$m and not more than 2 $\mu$m. When the average particle size is within the range of not less than 0.05 $\mu$m and not more than 2 $\mu$m, the function of reinforcing the grain boundary phase is increased. When the average particle size is less than 0.05 $\mu$m, there is a possibility that the function of reinforcing the grain boundary phase may be insufficient. Also, when the average particle size is greater than 2 $\mu$m, there is a possibility that the gaps between the silicon nitride crystal grains and the zirconium oxide particles may be large. Large gaps cause the occurrence of voids. It is therefore favorable for the average particle size of the zirconium oxide particles to be within the range of not less than 0.05 $\mu$m and not more than 2 $\mu$m, and more favorably within the range of not less than 0.1 $\mu$m and not more than 1 $\mu$m.

Also, it is favorable for the total area of the zirconium oxide particles in a 100 $\mu$m$\times$100 $\mu$m measurement area to be within the range of not less than 0.01% and not more than 15%. By setting the area ratio in the 100 $\mu$m$\times$100 $\mu$m measurement area to be not less than 0.01% and not more than 15%, the zirconium oxide particles can be distributed more uniformly. The effects can be further increased by controlling the average particle size and area ratio of the zirconium oxide particles. More favorably, the total area of the zirconium oxide particles is within the range of not less than 0.01% and not more than 15% when any measurement area in any cross section is measured.

A method for measuring the average particle size and area ratio of the zirconium oxide particles will now be described. First, any cross section is obtained from the silicon nitride sintered body. The pretreatment of the cross section is not limited as long as the cross section can be observed by a scanning electron microscope (SEM). For example, it is favorable to observe an ion-milled cross section with SEM. The cross section on which the XRD analysis was performed may be used in the observation by SEM. In such a case, first, an enlarged photograph (a SEM photograph) of not less than 1,000 times is imaged by SEM. A 100 $\mu$m$\times$100 $\mu$m measurement area is randomly extracted from the enlarged photograph. The particle sizes of the zirconium oxide particles visible in the measurement area are measured. The distance between the two most distant points on the outer edge of a particle is measured as the particle size. The average value of the particle sizes measured in the 100 $\mu$m$\times$100 $\mu$m measurement area is used as the average particle size. When it is difficult to discriminate zirconium oxide particles in the SEM photograph, elemental mapping of zirconium and oxygen may be performed using energy dispersive X-ray analysis (EDX). When a hybrid Zr oxide is included, the zirconium oxide particles may be discriminated by also using mapping of the hybrid elements. For example, the regions where zirconium and oxygen overlap in the EDX elemental mapping can be determined to be zirconium oxide particles.

It is favorable for the maximum diameter of the voids in the silicon nitride sintered body to be not more than 3 $\mu$m. A SEM photograph of any cross section of the silicon nitride sintered body is used to measure the maximum diameter of the voids. The SEM photograph that is used to measure the particle sizes of the zirconium oxide particles may be used to measure the maximum diameter of the voids. The major diameters of the voids visible in the SEM photograph are measured. The distance between the two most distant points on the outer edge of a void is measured as the major diameter of the void. The largest major diameter among the voids visible in the 100 $\mu$m$\times$100 $\mu$m measurement area is used as the maximum diameter of the voids. It is more favorable for the maximum diameter of the voids to be not more than 1 $\mu$m.

To observe the voids, the SEM photograph is analyzed using image analysis software. ImageJ or equivalent or better software is used as the image analysis software. Contrast occurs between the voids and other portions in the SEM photograph of the cross section. For example, the color of voids appear blacker and darker than the colors of portions other than the voids. The contrast difference can be utilized to discriminate between the voids and other portions by binarizing the SEM photograph.

A value that is obtained using a "mode technique" or a "discriminant analysis binarization technique" is used as the threshold for binarization. When the image analysis software includes the function of a discriminant analysis binarization technique, the discriminant analysis binarization technique of the image analysis software is used. In the discriminant analysis binarization technique, the threshold is determined uniquely by the analysis software. It is therefore easy to discriminate the voids. For example, in the SEM photograph, the region that appears white around the void is the boundary between the void and the silicon nitride sintered body. Accordingly, the region that appears white around the void should not be counted as the void. Also, the silicon nitride sintered body is gray in the SEM photograph. By using the threshold obtained by the "mode technique" or the "discriminant analysis binarization technique", the void can be shown as black; and the silicon nitride sintered body and the white region around the void can be shown as white. By using a binarized image, the voids that are visible in the SEM photograph and the other regions can be discriminated.

For example, in a 100 $\mu$m$\times$100 $\mu$m measurement area, it is favorable for the average particle size of the zirconium oxide particles to be not less than 0.05 $\mu$m and not more than 2 $\mu$m, the total area of the zirconium oxide particles to be not less than 0.01% and not more than 15%, and the maximum diameter of the voids to be not more than 3 $\mu$m. More favorably, in the 100 $\mu$m$\times$100 $\mu$m measurement area, the average particle size of the zirconium oxide particles is not less than 0.1 $\mu$m and not more than 1 $\mu$m; the total area of the zirconium oxide particles is not less than 0.01% and not more than 15%; and the maximum diameter of the voids is not more than 1 $\mu$m.

For a silicon nitride sintered body having the configuration described above, even for a firing temperature of less than 1,650 °C, a three-point bending strength of not less than 600 MPa can be obtained. Also, a dielectric strength of not less than 13 kV/mm can be obtained. The three-point bending strength is measured in accordance with JIS-R-1601 (2008). The dielectric strength is measured in accordance with the dielectric breakdown strength of JIS-C-2141 (1992). JIS-R-1601 corresponds to ISO 14704. JIS-C-2141 corresponds to IEC 672-2.

Such a silicon nitride sintered body can be used in various fields. The silicon nitride sintered body according to the embodiment can be used in a wear-resistant member. FIG. 1 is a schematic view showing a bearing ball, which is an example of the wear-resistant member. In FIG. 1, 1 is a bearing ball. The bearing ball 1 is a true spherical ball. The bearing ball 1 that is made of the silicon nitride sintered body has excellent wear resistance.

A bearing has a structure in which the bearing balls 1 are placed between an inner ring and an outer ring. Generally, the inner ring and the outer ring are made of bearing steel. There are cases where electrolytic corrosion occurs due to high-speed rotation of the bearing. When the bearing ball 1 according to the embodiment is used, the insulative properties of the silicon nitride sintered body are high, and so the occurrence of electrolytic corrosion can be suppressed.

Also, friction is generated at the surface of the bearing ball 1. The silicon nitride sintered body according to the embodiment has excellent wear resistance, and therefore has excellent durability. Other than bearing balls, wear-resistant members include various roll materials such as those of rolling, engine parts such as cam rollers, bearing members, compressor vanes, gas turbine blades, friction stir welding tool members, etc.

Also, the silicon nitride sintered body according to the embodiment can be used in a substrate for semiconductor devices. FIG. 2 is a schematic view showing an example of a substrate for semiconductor devices. In FIG. 2, 2 is a substrate for semiconductor devices. Although FIG. 2 illustrates a quadrilateral substrate, the shape of the substrate may be circular, L-shaped, or U-shaped.

A circuit part, a semiconductor element, etc., are provided on the substrate for semiconductor devices 2. The circuit part is a metal plate, a metalized layer, etc. The circuit part is bonded to the substrate via a bonding layer as necessary. Also, a semiconductor device is obtained by mounting a semiconductor element, etc., to the circuit part. By using the silicon nitride sintered body according to the embodiment, the substrate for semiconductor devices 2 that has excellent strength and insulative properties can be provided.

A method for producing the silicon nitride sintered body according to the embodiment will now be described. The method for producing the silicon nitride sintered body according to the embodiment is not particularly limited as long as the silicon nitride sintered body has the configuration described above. Here, a method for obtaining the silicon nitride sintered body with a high yield will be described.

The method for producing the silicon nitride sintered body according to the embodiment includes a process of making a compact, a process of making a degreased body, a placement process of the degreased body, a placement process of a packing powder, and a firing process. The compact is made by mixing a silicon nitride powder and at least a zirconium compound powder, and by molding the mixed powder. The degreased body is made by degreasing the compact. The degreased body and the packing powder are placed inside a firing chamber. In the firing process, the degreased body is fired at less than 1,650 °C inside the firing chamber in which the packing powder is placed.

FIG. 3 is a top view showing an example of a firing chamber. FIG. 4 is a side view showing another example of a firing chamber. In FIGS. 3 and 4, the reference numeral 3 is a firing chamber, the reference numeral 4 is an exterior wall, the reference numeral 5 is an interior wall, the reference numeral 6 is a packing powder, the reference numeral 7 is a degreased body, the reference numeral 8 is a lid part, and the reference numeral 9 is a floor part. FIGS. 3 and 4 are drawings that schematically show the interior of the firing chamber of a furnace.

First, a process of making the compact is performed. At least a zirconium compound powder is mixed with a silicon nitride powder. It is favorable for the silicon nitride included in the silicon nitride powder to be the $\alpha$-type. It is favorable for the alpha percentage of the silicon nitride to be not less than 90%. It is favorable for the oxygen amount included in the silicon nitride to be not more than 2 mass%, and for the average particle size of the silicon nitride to be not more than 3 $\mu$m. Grain growth of the $\alpha$-silicon nitride powder into the $\beta$-type occurs in the firing process. Due to the grain growth, both $\alpha$-silicon nitride crystal grains and $\beta$-silicon nitride crystal grains can be present. A $\beta$-silicon nitride powder may be added as necessary.

Examples of the zirconium compound powder include a zirconium oxide powder or a hybrid Zr oxide. It is favorable for the ratio of zirconium oxide in the zirconium compound powder to be within the range of not less than 90 mass% and not more than 100 mass%. At least one of a monoclinic zirconium oxide powder, a tetragonal zirconium oxide powder, or a cubic zirconium oxide powder can be used. It is favorable to use a monoclinic zirconium oxide powder as the raw material powder. Monoclinic is stable at room temperature. Also, examples of the hybrid Zr oxide include partially stabilized zirconia or fully stabilized zirconia. It is favorable for partially stabilized zirconia or fully stabilized zirconia to be tetragonal. Tetragonal partially stabilized zirconia or fully stabilized zirconia is stable at room temperature. Therefore, crystal change fluctuation due to the effects of the heat of the firing process can be reduced. It is favorable for the average particle size of the zirconium compound powder to be not more than 3 $\mu$m. Zirconium oxide is used as a sintering aid to perform low-temperature firing at less than 1,650 °C. Also, it is favorable for the added amount of the zirconium compound powder to be within the range of not less than 0.1 mass% and not more than 10 mass% of zirconium when converted to oxide. The XRD peaks described above are easily controlled within this range.

A sintering aid other than zirconium oxide may be added to the raw material powder. For example, one or more elements are selected from a rare-earth element, aluminum, and magnesium; and at least one selected from an oxide, a nitride, and an oxynitride of the elements is used as the sintering aid. The oxide, the nitride, and the oxynitride each may be a hybrid oxide, a hybrid nitride, or a hybrid oxynitride. Examples of the rare-earth element include yttrium and lanthanoid elements.

In particular, it is favorable to add an oxide as the sintering aid. Aluminum oxide or magnesium oxide reacts with zirconium oxide in the firing process to form a hybrid Zr oxide. Fully stabilized zirconia or partially stabilized zirconia is formed according to the solid solution amount of magnesium. Fully stabilized zirconia or partially stabilized zirconia tends to be tetragonal.

Also, a Zr-Al-O crystal compound is formed when zirconium oxide and aluminum oxide react. Also, there are cases where when aluminum oxide reacts with silicon nitride to form $\alpha$-sialon or $\beta$-sialon. Zirconium oxide that is added in the monoclinic state changes to tetragonal and is stabilized by reacting with another sintering aid. The monoclinic zirconium oxide may remain as-is without being completely reacted with the other sintering aids.

The rare-earth element performs the role of forming a stabilizing phase by dissolving in zirconium oxide. Also, the rare-earth element is a sintering aid effective for improving the sinterability. The rare-earth element can form a crystal compound by reacting with silicon nitride, aluminum, and magnesium. Examples include rare-earth element-Al-O, rare-earth element-Mg-O, rare-earth element-Al-Mg-O, rare-earth element-Al-O-N, rare-earth element-Mg-O-N, rare-earth element Al-Mg-O-N, rare-earth element-Si-Al-O, rare-earth element-Si-Mg-O, rare-earth element-Si-Al-Mg-O, rare-earth element-Si-Al-O-N, rare-earth element-Si-Mg-O-N, rare-earth element-Si-Al-Mg-O-N, and other types of crystal compounds. These crystal compounds are effective for controlling $I_{36.7}$ or $I_{41.9}$.

It is favorable for the added amount of the compound of the element selected from a rare-earth element, aluminum, and magnesium to be within the range of not less than 1 mass% and not more than 15 mass% in total. The compound is at least one selected from an oxide, a nitride, and an oxynitride. Also, other than $Al_2O_3$ and MgO, spinel ($MgAl_2O_4$) may be used as the oxide of aluminum or the oxide of magnesium.

Also, examples of sintering aids other than those described above include silicon oxide. Silicon oxide has the effect of lowering the eutectic temperature with zirconium oxide. Therefore, an effect of lowering the firing temperature is obtained. It is favorable for the added amount of silicon oxide to be within the range of not less than 0.1 mass% and not more than 5 mass%. Impurity oxygen included in the silicon nitride powder may be added as the silicon oxide.

The silicon nitride powder, the zirconium oxide powder (including the hybrid Zr oxide), and other sintering aid powders are mixed. Also, a raw material powder slurry is prepared by mixing a binder and a solvent. Then, a compact is made using the raw material powder slurry. Various methods such as die pressing, cold isostatic pressing (CIP), doctor blade, etc., can be used to make the compact.

Then, a process of making a degreased body by degreasing the compact is performed. The degreasing process is a process of removing or reducing the binder and the solvent in the compact. It is favorable to perform the degreasing process within a temperature range of not less than 400 °C and not more than 600 °C. The degreasing process can be performed in nitrogen, in ambient air, or in a vacuum. The degreased body is obtained by performing the degreasing process.

Then, a process of placing the degreased body that is made in a sintering chamber is performed. In the example shown in FIG. 4, the degreased body 7 is placed on the floor part 9 inside the firing chamber. A firing container may be used as necessary. Also, the degreased bodies 7 may be stacked with each other; and the firing containers may be stacked. When the degreased bodies 7 are stacked with each other, a release agent or a floorboard may be placed between the degreased bodies 7.

Then, a process of placing a packing powder inside the sintering chamber is performed. The firing chamber 3 is a room inside the furnace, and is a room for firing the degreased body 7. Also, the exterior wall 4 and the interior wall 5 are inside the firing chamber 3. The packing powder 6 is placed in the gap between the exterior wall 4 and the interior wall 5. The space in which the degreased body 7 is placed communicates with the space between the exterior wall 4 and the interior wall 5. The process of placing the packing powder 6 may be after placing the degreased body 7 in the firing chamber 3, or may be before placing the degreased body 7 in the firing chamber 3.

As shown in FIG. 3, the packing powder 6 is placed in the space between the exterior wall 4 and the interior wall 5. The space surrounds the degreased body 7 in horizontal directions. Also, as shown in FIG. 4, the lid part 8 that is positioned on the degreased body 7 may be provided. When the lid part 8 is provided, the packing powder 6 also is placed in the space inside the lid part 8. The space in which the degreased body 7 is placed communicates with the space inside the lid part 8. When the packing powder 6 cannot be placed inside the lid part 8, the packing powder 6 may be placed on the lid part 8.

In the example shown in FIGS. 3 and 4, the packing powder 6 is placed between the exterior wall 4 and the interior wall 5. When there is no exterior wall 4 or interior wall 5 inside the firing chamber 3, the packing powder 6 may be placed at the periphery of the firing container in which the degreased body 7 is stored. Similarly, when there is no lid part 8, the packing powder 6 may be placed on the firing container. It is unnecessary to form a completely sealed space from the exterior wall 4, the interior wall 5, or the firing container inside the firing chamber 3. The gas that is emitted from the degreased body 7 may be emitted outside through the exterior wall 4, the interior wall 5, or the firing container. Therefore, a hole or a passageway through which a gas flows may be provided in the exterior wall 4, the interior wall 5, or the firing container.

It is favorable for the packing powder 6 to be at least one selected from silicon nitride, silicon oxide, magnesium oxide, and talc. The silicon nitride powder may be either the $\alpha$-type and the $\beta$-type. Also, talc is a hybrid oxide represented by $MgO \cdot SiO_2$. Such a packing powder 6 is effective for controlling the partial pressure in the firing process.

Then, a firing process of firing the degreased body 7 at less than 1,650 °C is performed. It is favorable for the firing temperature to be less than 1,550 °C. Here, "low-temperature firing" refers to firing the degreased body at less than 1,650 °C, or even less than 1,550 °C. The pressure when firing may be one of atmospheric pressure, pressurized or decompressed. Also, the firing atmosphere may be one of ambient air, a nonoxidizing atmosphere, or in a vacuum. Also, it is favorable for the pressure change to be not more than 0.1 MPa in the firing process. By using the packing powder 6, the pressure change of the firing process can be suppressed to be not more than 0.1 MPa.

As described above, the zirconium oxide powder is a sintering aid effective for firing at less than 1,650 °C. On the other hand, zirconium oxide easily forms zirconium nitride by reacting with silicon nitride. In particular, zirconium nitride is easily formed by zirconium oxide and silicon nitride reacting at about 1,600 °C.

Also, the magnesium oxide (MgO) of the sintering aid can form a liquid phase at a low temperature. In the firing process, MgO volatilizes as Mg. The volatilized Mg has strong reducibility. $ZrO_2$ has a strong reduction effect when the Mg included in the degreased body 7 volatilizes. As a result, $ZrO_2$ is reduced, and Zr is formed. The Zr reacts with nitrogen to form ZrN (zirconium nitride). Although zirconium oxide or magnesium oxide is a sintering aid effective for low-temperature firing, conventionally, much ZrN, which degrades the characteristics, had been formed. As a result, there were cases where $I_{33.9}/I_{27.0}$ was greater than 1.0.

ZrN is mainly formed in the surface layer portion of the silicon nitride sintered body. It is possible to remove the ZrN of the surface layer portion by scraping off about several 10 $\mu$m of the surface layer portion. On the other hand, the process of deleting the surface layer portion may cause an increase of the production cost. It is therefore favorable to suppress the formation of ZrN in the sintering process. Also, ZrN is electrically-conductive. When a silicon nitride sintered body that includes ZrN is used in a bearing ball, there is a possibility that electrolytic corrosion may be caused. A silicon nitride sintered body that includes ZrN may cause insulation defects when used as a substrate for semiconductor devices. The vapor pressures of rare-earth oxides and aluminum oxide are less than the vapor pressures of $ZrO_2$ and MgO. Therefore, rare-earth oxides and aluminum oxide are sintering aids having low reducibility.

By using the packing powder 6, the change of $ZrO_2$ into ZrN can be suppressed. That is, the reduction of $ZrO_2$ can be suppressed. Also, the reduction of MgO can be suppressed.

The use of the packing powder 6 increases the hermeticity inside the firing chamber 3. Improving the hermeticity leads to suppression of the pressure change inside the firing chamber 3. Also, by using at least one selected from silicon nitride, silicon oxide, magnesium oxide, and talc as the packing powder 6, the pressure change of the firing process can be set to be not more than 0.1 MPa. The vapor pressures of silicon nitride, silicon oxide, magnesium oxide, and talc are equal to or greater than the vapor pressure of zirconium oxide. Because the packing powder 6 is reduced earlier than zirconium oxide, the zirconium oxide inside the degreased body 7 is not easily nitrided.

For example, when the packing powder 6 includes a silicon nitride powder or a silicon oxide powder, SiO (silicon monoxide) gas is discharged from the packing powder 6. The space inside the firing chamber 3 is filled with the SiO gas discharged from the packing powder 6, thereby making it difficult to nitride the zirconium oxide inside the degreased body 7. When the packing powder 6 includes magnesium oxide or talc, magnesium is discharged from the packing powder 6 when firing. The pressure of magnesium in the space inside the firing chamber 3 is increased. As a result, volatilization of magnesium from the degreased body 7 is suppressed, and the reduction of $ZrO_2$ by the volatilization of Mg from the degreased body 7 can be suppressed. As a result, the XRD peaks of zirconium oxide and/or zirconium nitride can be controlled. Also, the reduction of the MgO added as a sintering aid can be suppressed. According to experiments performed by the inventor of the application, it was found that the Mg present in the space inside the firing chamber 3 does not easily have a reduction effect on the $ZrO_2$ included in the degreased body 7. In other words, it was found that even when the partial pressure of Mg in the space inside the firing chamber 3 is high, the reduction reaction of $ZrO_2$ can be effectively suppressed by suppressing the volatilization of Mg from the degreased body 7.

Also, when a large quantity of the degreased body 7 is fired simultaneously to improve the suitability for mass production, gas is produced from the large quantity of the degreased body 7 at the same timing. As a result, the pressure change of the firing process is large. By discharging the gas from the packing powder 6 and by suppressing the production amount of the gas from the degreased body 7, the pressure change of the firing process can be controlled to be not more than 0.1 MPa.

It is favorable for the firing temperature to be less than 1,650 °C, and more favorably less than 1,550 °C. As described above, an $\alpha$-silicon nitride powder is used as the raw material powder. The $\alpha$-silicon nitride powder undergoes grain growth into $\beta$-silicon nitride crystal grains in the firing process. By setting the firing temperature to be low, i.e., less than 1,650 °C, the grain growth into the β-silicon nitride crystal grains can be suppressed. As a result, the ratio of the α-silicon nitride crystal grains and the β-silicon nitride crystal grains can be controlled. As a result, $I_{35.3}/I_{27.0}$ can be controlled. Also, the control of the grain growth of the β-silicon nitride crystal grains also leads to control of the distribution of zirconium oxide particles. Also, the maximum diameter of the voids of the silicon nitride sintered body can be set to be not more than 1 μm.

For example, when the same furnace (batch electric furnace) is used to perform the firing process at 1,650 °C, a power reduction of about 15% is possible compared to when the firing process is performed at 1,800 °C. Also, low-temperature firing makes it possible to fire at atmospheric pressure. Cost reduction is possible because pressure control is unnecessary. Also, the life of setters, insulation, etc., inside the furnace also can be extended. A silicon nitride sintered body that can be fired at a low temperature is effective for power reduction and cost reduction.

According to the production method described above, a silicon nitride sintered body that has a relative density of not less than 98% can be obtained. The relative density can be determined by Archimedes' method. Even for low-temperature firing at less than 1,650 °C, the relative density can be not less than 98%. Also, a silicon nitride sintered body that has a three-point bending strength of not less than 600 MPa can be obtained. A silicon nitride sintered body that has a dielectric strength of not less than 13 kV/mm can be obtained. Although the lower limit of the firing temperature is not particularly limited, it is favorable for the lower limit to be not less than 1,200 °C. When less than 1,200 °C, there is a possibility that the densification of the silicon nitride sintered body may be insufficient, and the maximum diameter of the voids cannot be 1 μm or less. It is therefore favorable for the firing temperature to be within the range of not less than 1,200 °C but less than 1,650 °C, and more favorably not less than 1,300 °C but less than 1,550 °C.

An additional heat treatment may be performed on the silicon nitride sintered body thus obtained as necessary. Examples of the additional heat treatment include hot isostatic pressing (HIP), a warp correction process, etc. A silicon nitride sintered body that has a relative density of not less than 99% can be obtained by HIP processing. Also, the three-point bending strength of the silicon nitride sintered body can be increased to be not less than 900 MPa by HIP processing. The heat treatment temperature of the additional heat treatment process is arbitrary. Although it is favorable for the additional heat treatment process to be performed at less than 1,650 °C, the additional heat treatment process may be performed at not less than 1,650 °C.

(Examples)

(Examples 1 to 14 and comparative examples 1 to 4)

An α-silicon nitride powder was prepared as a raw material powder. The average particle size of the α-silicon nitride powder was not more than 3 μm; the impurity oxygen amount was 1.3 mass%; and the alpha percentage was not less than 90%. A zirconium oxide powder (including hybrid Zr oxides), an yttrium oxide powder, an aluminum oxide powder, a magnesium oxide powder, a spinel powder, and a silicon dioxide powder were prepared as sintering aid powders. The average particle size of the sintering aid powders was not more than 3 μm. The silicon nitride powders and the sintering aid powders were mixed according to the mixing ratios of Table 1. The total of the silicon nitride powder and the sintering aid powders was used as 100 mass% for the mixing ratios. In the crystal structure of the zirconium oxide powder (the hybrid Zr oxides) recited in Table 1, "monoclinic" indicates that a monoclinic zirconium oxide powder was used. "Tetragonal" indicates that a tetragonal yttrium-stabilized zirconia powder was used. The spinel powder of the sintering aid was $MgAl_2O_4$.

[Table 1]

| | Silicon nitride powder | Zirconium oxide powder (hybrid Zr oxides) | | Yttrium oxide powder | Aluminum oxide powder | Magnesium oxide powder | Spinel powder | Silicon oxide powder |
|---|---|---|---|---|---|---|---|---|
| | Mass% | Mass% | Crystal structure | Mass% | Mass% | Mass% | Mass% | Mass% |
| Example 1 | 84 | 4 | Monoclinic | – | 6 | 6 | – | – |
| Example 2 | 90 | 4 | Monoclinic | – | – | – | 6 | – |
| Example 3 | 90 | 4 | Tetragonal | – | – | – | 6 | – |
| Example 4 | 90 | 4 | Monoclinic | – | – | – | 6 | – |
| Example 5 | 84 | 4 | Monoclinic | – | 6 | 6 | – | – |
| Example 6 | 84 | 4 | Monoclinic | – | 6 | 6 | – | – |
| Example 7 | 85 | 9 | Monoclinic | – | 3 | 3 | – | – |
| Example 8 | 88 | 6 | Monoclinic | 3 | – | 3 | – | – |
| Example 9 | 90 | 4 | Monoclinic | – | – | – | 6 | – |
| Example 10 | 88 | 4 | Monoclinic | – | – | – | 6 | 2 |
| Example 11 | 88 | 6 | Tetragonal | 3 | – | 3 | – | – |
| Example 12 | 90 | 4 | Tetragonal | – | – | – | 6 | – |
| Example 13 | 90 | 4 | Tetragonal | – | – | – | 6 | – |
| Example 14 | 85 | 9 | Tetragonal | – | 3 | 3 | – | – |
| Comparative example 1 | 94 | – | – | – | – | – | 6 | – |
| Comparative example 2 | 74 | 20 | Monoclinic | – | – | – | 6 | – |
| Comparative example 3 | 90 | 4 | Tetragonal | – | – | – | 6 | – |
| Comparative example 4 | 90 | 4 | Monoclinic | – | – | – | 6 | – |

In the examples, a prescribed amount of at least one of the silicon nitride powder, the zirconium oxide powder, the yttrium oxide powder, the aluminum oxide powder, the magnesium oxide powder, the spinel powder, or the silicon dioxide powder was admixed. In the comparative example 1, zirconium oxide was not added. In the comparative example 2, a large amount of zirconium oxide powder was added. In the comparative example 3, firing was performed without using a packing powder as described below. In the comparative example 4, firing was performed at 1,800 °C as described below.

The raw material powders were mixed; a binder and a solvent were added; and a raw material powder slurry was made using a ball mill. Only the example 9 was made using a planetary mill at 400 rpm for 1 hour. The slurries were dried and powderized, and die pressing was used to make compacts. A degreasing process of the compacts was performed in a range of not less than 400 °C and not more than 600 °C.

Then, the degreased bodies were placed in a firing chamber. A packing powder was placed between the exterior wall and the interior wall inside the firing chamber for the examples 1 to 14, the comparative examples 1 to 2, and the comparative example 4. Also, the packing powder was placed on the lid part of the firing chamber. On the other hand, the packing powder was not provided for the comparative example 3. The firing process was performed using the conditions shown in Table 2.

[Table 2]

| | Packing powder | Firing temperature (°C) | Firing time (H) | Pressure change ≤ 0.1MPa? |
|---|---|---|---|---|
| Example 1 | Silicon nitride + magnesium oxide | 1600 | 8 | YES |
| Example 2 | Silicon nitride + magnesium oxide | 1600 | 10 | YES |
| Example 3 | Silicon nitride + magnesium oxide | 1600 | 9 | YES |
| Example 4 | Magnesium oxide | 1540 | 10 | YES |
| Example 5 | Silicon dioxide | 1540 | 8 | YES |
| Example 6 | Talc | 1540 | 8 | YES |
| Example 7 | Silicon nitride + magnesium oxide | 1600 | 8 | YES |
| Example 8 | Silicon nitride + magnesium oxide | 1600 | 10 | YES |
| Example 9 | Silicon nitride + magnesium oxide | 1600 | 8 | YES |
| Example 10 | Silicon nitride + magnesium oxide | 1600 | 10 | YES |
| Example 11 | Silicon nitride + magnesium oxide | 1600 | 10 | YES |
| Example 12 | Silicon nitride + magnesium oxide | 1500 | 12 | YES |
| Example 13 | Silicon dioxide | 1600 | 10 | YES |
| Example 14 | Silicon nitride + magnesium oxide | 1600 | 10 | YES |
| Comparative example 1 | Silicon nitride + magnesium oxide | 1600 | 10 | YES |
| Comparative example 2 | Silicon nitride + magnesium oxide | 1600 | 10 | YES |
| Comparative example 3 | — | 1600 | 10 | NO |
| Comparative example 4 | Silicon nitride + magnesium oxide | 1800 | 10 | NO |

The silicon nitride sintered bodies were made by the processes described above. The zirconium content was within the range of not less than 0.1 mass% and not more than 10 mass% when converted to oxide for the examples 1 to 14 and the comparative examples 3 to 4. The silicon nitride sintered body did not include zirconium for the comparative example 1. The zirconium content in the silicon nitride sintered body was greater than 10 mass% when converted to oxide for the comparative example 2. Because the packing powder was not used for the comparative example 3, the pressure change in the firing process was greater than 0.1 MPa. For the comparative example 4, the firing temperature was high, and so the pressure change in the firing process was greater than 0.1 MPa even when a packing powder was used.

Then, XRD analysis of an arbitrary cross section was performed for each silicon nitride sintered body. The conditions and method of the XRD analysis were as described above. The relationships of the peak intensities observed in the XRD analysis are shown in Table 3.

[Table 3]

| | XRD peak intensity ratio | | | | | |
|---|---|---|---|---|---|---|
| | $I_{35.3}/I_{27.0}$ | $I_{33.9}/I_{27.0}$ | $I_{28.2}/I_{27.0}$ | $I_{30.1}/I_{27.0}$ | $I_{36.7}/I_{27.0}$ | $I_{41.9}/I_{27.0}$ |
| Example 1 | 0.05 | 0.03 | 0.04 | 0.02 | 0.03 | 0.01 |
| Example 2 | 0.03 | 0.03 | 0.04 | 0.02 | 0.02 | 0.01 |
| Example 3 | 0.02 | 0.03 | 0.02 | 0.02 | 0.05 | 0.01 |
| Example 4 | 0.32 | 0.02 | 0.03 | 0.11 | 0.02 | 0.01 |
| Example 5 | 0.33 | 0.05 | 0.05 | 0.15 | 0.02 | 0.01 |
| Example 6 | 0.27 | 0.02 | 0.04 | 0.11 | 0.02 | 0.01 |
| Example 7 | 0.03 | 0.04 | 0.08 | 0.15 | 0.02 | 0.01 |
| Example 8 | 0.02 | 0.02 | 0.02 | 0.05 | 0.01 | 0.01 |
| Example 9 | 0.03 | 0 | 0.04 | 0.02 | 0 | 0 |
| Example 10 | 0.02 | 0.02 | 0.02 | 0.04 | 0.01 | 0.02 |
| Example 11 | 0.01 | 0.02 | 0.01 | 0.05 | 0 | 0.02 |
| Example 12 | 0.28 | 0 | 0.01 | 0.10 | 0.01 | 0 |
| Example 13 | 0.02 | 0.75 | 0 | 0.02 | 0.02 | 0.01 |
| Example 14 | 0.05 | 0.05 | 0 | 0.25 | 0.02 | 0.01 |
| Comparative example 1 | 0.50 | — | — | — | 0.10 | 0.10 |
| Comparative example 2 | 0.32 | 3.8 | 0.11 | 0.14 | 0.02 | 0.01 |
| Comparative example 3 | 0.12 | 1.54 | 0.02 | 0.02 | 0.02 | 0.03 |
| Comparative example 4 | <0.01 | 1.82 | 0.02 | 0.02 | 0.01 | 0.01 |

It can be seen from Table 3 that $I_{35.3}/I_{27.0}$ and $I_{33.9}/I_{27.0}$ were within the prescribed ranges for the silicon nitride sintered bodies according to the examples. Also, zirconium was present as zirconium oxide in the silicon nitride sintered bodies according to the examples. The peak ratio being 0 means that the peak intensity of the molecule was below the detection limit.

In contrast, $I_{33.9}/I_{27.0}$ was greater than 1.0 for the comparative example 2. In the comparative example 2, the added amount of the zirconium oxide powder was high, and so a lot of ZrN was formed. In the comparative example 3, a packing powder was not used, and so a lot of ZrN was formed. In the comparative example 4, the firing temperature was high, and so silicon nitride and zirconium oxide were formed in the sintered body interior; and much zirconium nitride was formed at the surface of the sintered body.

Then, arbitrary cross sections of the silicon nitride sintered body were imaged by SEM. The average particle size and total area of the zirconium oxide particles were measured using the SEM photograph thus obtained. Also, the maximum diameter of the voids was measured. The detailed conditions were as described above. It was checked whether or not the total area of the zirconium oxide particles was within the range of not less than 0.01% and not more than 15% for an arbitrary 100 $\mu$m×100 $\mu$m measurement area. Also, the relative density of the silicon nitride sintered body was measured. The relative density was measured using Archimedes' method. The results are shown in Table 4.

## [Table 4]

| | Zirconium oxide | | Void maximum diameter (μm) | Relative density (%) |
|---|---|---|---|---|
| | Average particle size (μm) | 0.01 ≤ Total area ≤ 15%? | | |
| Example 1 | 0.7 | YES | 0.4 | 98 |
| Example 2 | 0.5 | YES | 0.3 | 99 |
| Example 3 | 0.5 | YES | 0.2 | 99 |
| Example 4 | 0.6 | YES | 0.7 | 98 |
| Example 5 | 0.7 | YES | 0.9 | 98 |
| Example 6 | 0.8 | YES | 0.5 | 98 |
| Example 7 | 0.6 | YES | 0.9 | 98 |
| Example 8 | 0.5 | YES | 0.3 | 99 |
| Example 9 | 0.5 | YES | 0.3 | 99 |
| Example 10 | 0.7 | YES | 0.3 | 99 |
| Example 11 | 0.6 | YES | 0.3 | 99 |
| Example 12 | 0.5 | YES | 0.4 | 96 |
| Example 13 | 0.5 | YES | 0.5 | 99 |
| Example 14 | 0.6 | YES | 0.3 | 99 |
| Comparative example 1 | — | — | 4.8 | 73 |
| Comparative example 2 | 3.8 | NO | 2.5 | 85 |
| Comparative example 3 | 1.0 | YES | 0.7 | 96 |
| Comparative example 4 | 1.5 | YES | 0.3 | 99 |

The average particle size and total area of the zirconium oxide particles were within the prescribed ranges for the silicon nitride sintered bodies according to the examples. Also, the maximum diameter of the voids was not more than 3 $\mu$m. Also, the relative density was not less than 96%; and the sintered body was sufficiently densified.

On the other hand, in the comparative example 1, zirconium oxide was not added, and so the voids were large, and the relative density was low. In the comparative example 2, the added amount of zirconium oxide was high, and so the voids were large, and the relative density was low. In the comparative example 3, a packing powder was not used, and so a lot of zirconium nitride was formed, and the insulative properties were low as described below. In the comparative example 4, the firing temperature was high, and so a lot of zirconium nitride was formed. In other words, it was found that the compositions of the examples were unsuited to high-temperature firing.

Then, the three-point bending strength and the dielectric strength were measured for each silicon nitride sintered body. The measurement conditions were as described above. It was measured whether or not the dielectric strength was not less than 14 kV/mm. The results are shown in Table 5.

[Table 5]

| | Three-point bending strength (MPa) | Dielectric strength ≥ 14kV/mm ? |
|---|---|---|
| Example 1 | 700 | YES |
| Example 2 | 720 | YES |
| Example 3 | 740 | YES |
| Example 4 | 520 | YES |
| Example 5 | 580 | YES |
| Example 6 | 600 | YES |
| Example 7 | 630 | YES |
| Example 8 | 590 | YES |
| Example 9 | 650 | YES |
| Example 10 | 710 | YES |
| Example 11 | 700 | YES |
| Example 12 | 650 | YES |
| Example 13 | 680 | YES |
| Example 14 | 550 | YES |
| Comparative example 1 | 300 | NO |
| Comparative example 2 | 450 | NO |
| Comparative example 3 | 680 | NO |
| Comparative example 4 | 920 | NO |

It can be seen from Table 5 that the silicon nitride sintered bodies according to the examples had excellent three-point bending strength and dielectric strength. Excellent characteristics were obtained even for low-temperature firing at less than 1,650 °C. In the comparative examples, the silicon nitride sintered body was not densified, and so the strength and insulative properties were low.

Then, HIP processing was performed on the silicon nitride sintered bodies according to the examples 1 to 3. After HIP processing, the relative density and the three-point bending strength were measured. The results are shown in Table 6.

[Table 6]

|  | Silicon nitride sintered body | Three-point bending strength (MPa) | Relative density (%) |
|---|---|---|---|
| Example 1B | Example 1 | 940 | >99 |
| Example 2B | Example 2 | 1010 | >99 |
| Example 3B | Example 3 | 1100 | >99 |

It can be seen from Table 6 that by performing HIP processing, densification proceeded, and the strength of the silicon nitride sintered body was increased.

Also, according to the examples, the consumed energy can be reduced because the firing process can be performed at a low temperature of less than 1,650 °C.

Embodiments of the invention include the following features.

Feature 1

A silicon nitride sintered body, comprising:

not less than 0.1 mass% and not more than 10 mass% of zirconium when converted to oxide,
when XRD analysis ($2\theta$) of any cross section of the silicon nitride sintered body is performed:

$$0.01 \leq I_{35.3}/I_{27.0} \leq 0.5,$$

and

$$0 \leq I_{33.9}/I_{27.0} \leq 1.0$$

being satisfied,
$I_{35.3}$ being a maximum peak intensity detected at 35.3°±0.2° based on α-silicon nitride crystal grains,
$I_{27.0}$ being a most intense peak detected at 27.0°±0.2° based on β-silicon nitride crystal grains,
$I_{33.9}$ being a most intense peak detected at 33.9°±0.2° based on zirconium nitride.

Feature 2

The silicon nitride sintered body according to Feature 1, wherein

in the XRD analysis ($2\theta$):

$$0.02 \leq I_{30.1}/I_{27.0} \leq 0.30$$

is satisfied, and
$I_{30.1}$ is a most intense peak detected at 30.1°±0.2° based on zirconium oxide.

Feature 3

The silicon nitride sintered body according to Feature 2, wherein

16

in the XRD analysis ($2\theta$):

$$0.01 \leq I_{28.2}/I_{27.0} \leq 0.30$$

is satisfied, and
$I_{28.2}$ is a most intense peak detected at 28.2°±0.2° based on zirconium oxide.

Feature 4

The silicon nitride sintered body according to any one of Features 1 to 3, wherein

in the XRD analysis ($2\theta$):

$$0 \leq I_{36.7}/I_{27.0} \leq 0.50,$$

or

$$0 \leq I_{41.9}/I_{27.0} \leq 0.50$$

is satisfied,
$I_{36.7}$ is a most intense peak detected at 36.7°±0.2°, and
$I_{41.9}$ is a most intense peak detected at 41.9°±0.2°.

Feature 5

The silicon nitride sintered body according to any one of Features 1 to 4, comprising:

oxide particles of the zirconium,
an average particle size of the oxide particles being not less than 0.05 $\mu$m and not more than 2 $\mu$m,
in a 100 $\mu$m×100 $\mu$m measurement area in any cross section of the silicon nitride sintered body, a total area of the oxide particles being within a range of not less than 0.01% and not more than 15%.

Feature 6

The silicon nitride sintered body according to any one of Features 1 to 5, wherein
in a 100 $\mu$m×100 $\mu$m measurement area in any cross section of the silicon nitride sintered body, a maximum diameter of voids is not more than 3 $\mu$m.

Feature 7

A wear-resistant member using the silicon nitride sintered body according to any one of Features 1 to 6.

Feature 8

A substrate for semiconductor devices using the silicon nitride sintered body according to any one of Features 1 to 6.

Feature 9

A method for producing a silicon nitride sintered body, comprising:

making a compact by mixing and molding a silicon nitride powder and at least a zirconium compound powder;
making a degreased body by degreasing the compact;
placing the degreased body in a firing chamber;
placing a packing powder inside the firing chamber; and
a firing process of firing the degreased body inside the firing chamber in which the packing powder is placed at less than 1,650 °C.

Feature 10

The method for producing the silicon nitride sintered body according to Feature 9, wherein a firing temperature in the firing process is less than 1,550 °C.

Feature 11

The method for producing the silicon nitride sintered body according to Feature 0, wherein a pressure change in the firing process is not more than 0.1 MPa.

Feature 12

The method for producing the silicon nitride sintered body according to Features 9 to 11, wherein the packing powder is at least one selected from silicon nitride, silicon oxide, magnesium oxide, and talc.

While certain embodiments of the inventions have been illustrated, these embodiments have been presented by way of example only, and are not intended to limit the scope of the inventions. These novel embodiments may be embodied in a variety of other forms; and various omissions, substitutions, modifications, etc., can be made without departing from the spirit of the inventions. These embodiments and their modifications are within the scope and spirit of the inventions, and are within the scope of the inventions described in the claims and their equivalents. Also, the embodiments above can be implemented in combination with each other.

[Reference Numeral List]

1 bearing ball
2 substrate for semiconductor devices
3 firing chamber
4 exterior wall
5 interior wall
6 packing powder
7 degreased body
8 lid part
9 floor part

**Claims**

1. A silicon nitride sintered body (1, 2), comprising:

    not less than 0.1 mass% and not more than 10 mass% of zirconium when converted to oxide,
    when XRD analysis ($2\theta$) of any cross section of the silicon nitride sintered body is performed:

$$0.01 \leq I_{35.3}/I_{27.0} \leq 0.5,$$

    and

$$0 \leq I_{33.9}/I_{27.0} \leq 1.0$$

    being satisfied,
    $I_{35.3}$ being a maximum peak intensity detected at 35.3°±0.2° based on $\alpha$-silicon nitride crystal grains,
    $I_{27.0}$ being a most intense peak detected at 27.0°±0.2° based on $\beta$-silicon nitride crystal grains,
    $I_{33.9}$ being a most intense peak detected at 33.9°±0.2° based on zirconium nitride.

2. The silicon nitride sintered body (1, 2) according to claim 1, wherein

    in the XRD analysis ($2\theta$):

$$0.02 \leq I_{30.1}/I_{27.0} \leq 0.30$$

is satisfied, and
$I_{30.1}$ is a most intense peak detected at 30.1°±0.2° based on zirconium oxide.

3. The silicon nitride sintered body (1, 2) according to claim 2, wherein

in the XRD analysis ($2\theta$):

$$0.01 \leq I_{28.2}/I_{27.0} \leq 0.30$$

is satisfied, and
$I_{28.2}$ is a most intense peak detected at 28.2°±0.2° based on zirconium oxide.

4. The silicon nitride sintered body (1, 2) according to any one of claims 1 to 3, wherein

in the XRD analysis ($2\theta$):

$$0 \leq I_{36.7}/I_{27.0} \leq 0.50,$$

or

$$0 \leq I_{41.9}/I_{27.0} \leq 0.50$$

is satisfied,
$I_{36.7}$ is a most intense peak detected at 36.7°±0.2°, and
$I_{41.9}$ is a most intense peak detected at 41.9°±0.2°.

5. The silicon nitride sintered body (1, 2) according to any one of claims 1 to 3, comprising:

oxide particles of the zirconium,
an average particle size of the oxide particles being not less than 0.05 $\mu$m and not more than 2 $\mu$m,
in a 100 $\mu$m×100 $\mu$m measurement area in any cross section of the silicon nitride sintered body, a total area of the oxide particles being within a range of not less than 0.01% and not more than 15%.

6. The silicon nitride sintered body (1, 2) according to claim 4, comprising:

oxide particles of the zirconium,
an average particle size of the oxide particles being not less than 0.05 $\mu$m and not more than 2 $\mu$m,
in a 100 $\mu$m×100 $\mu$m measurement area in any cross section of the silicon nitride sintered body, a total area of the oxide particles being within a range of not less than 0.01% and not more than 15%.

7. The silicon nitride sintered body (1, 2) according to any one of claims 1 to 3, wherein
in a 100 $\mu$m×100 $\mu$m measurement area in any cross section of the silicon nitride sintered body, a maximum diameter of voids is not more than 3 $\mu$m.

8. The silicon nitride sintered body (1, 2) according to claim 5, wherein
in the 100 $\mu$m×100 $\mu$m measurement area, a maximum diameter of voids is not more than 3 $\mu$m.

9. A wear-resistant member (1) using the silicon nitride sintered body according to any one of claims 1 to 3.

10. A wear-resistant member (1) using the silicon nitride sintered body according to claim 7.

11. A wear-resistant member (1) using the silicon nitride sintered body according to claim 8.

**12.** A substrate (2) for semiconductor devices using the silicon nitride sintered body according to any one of claims 1 to 3.

**13.** A substrate (2) for semiconductor devices (2) using the silicon nitride sintered body according to claim 7.

**14.** A substrate (2) for semiconductor devices (2) using the silicon nitride sintered body according to claim 8.

**15.** A method for producing a silicon nitride sintered body (1, 2), the method comprising:

making a compact by mixing and molding a silicon nitride powder and at least a zirconium compound powder;
making a degreased body (7) by degreasing the compact;
placing the degreased body (7) in a firing chamber (3);
placing a packing powder (6) inside the firing chamber (3); and
a firing process of firing the degreased body (7) inside the firing chamber (3) in which the packing powder (6) is placed at less than 1,650 °C.

**16.** The method for producing the silicon nitride sintered body (1, 2) according to claim 15, wherein a firing temperature in the firing process is less than 1,550 °C.

**17.** The method for producing the silicon nitride sintered body (1, 2) according to claim 15 or claim 16, wherein a pressure change in the firing process is not more than 0.1 MPa.

**18.** The method for producing the silicon nitride sintered body (1, 2) according to claim 15 or claim 16, wherein the packing powder (6) is at least one selected from silicon nitride, silicon oxide, magnesium oxide, and talc.

**19.** The method for producing the silicon nitride sintered body (1, 2) according to claim 17, wherein the packing powder (6) is at least one selected from silicon nitride, silicon oxide, magnesium oxide, and talc.

FIG. 1

FIG. 2

FIG. 3

FIG. 4

FIG. 5

| INTERNATIONAL SEARCH REPORT | International application No. |
|---|---|
| | **PCT/JP2023/031775** |

**A.    CLASSIFICATION OF SUBJECT MATTER**

*C04B 35/596*(2006.01)i; *C04B 35/64*(2006.01)i; *F16C 33/24*(2006.01)i; *F16C 33/32*(2006.01)i; *H05K 1/03*(2006.01)i
FI:    C04B35/596; F16C33/32; F16C33/24 A; H05K1/03 610D; C04B35/64

According to International Patent Classification (IPC) or to both national classification and IPC

**B.    FIELDS SEARCHED**

Minimum documentation searched (classification system followed by classification symbols)

C04B35/596; C04B35/64; F16C33/24; F16C33/32; H05K1/03

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C.    DOCUMENTS CONSIDERED TO BE RELEVANT**

| Category* | Citation of document, with indication, where appropriate, of the relevant passages | Relevant to claim No. |
|---|---|---|
| X | JP 2002-284586 A (NGK INSULATORS LTD) 03 October 2002 (2002-10-03) paragraph [0051], table 1, example 3 | 1-4 |
| A | | 5-19 |
| X | JP 54-148010 A (FIAT SPA) 19 November 1979 (1979-11-19) p. 2, upper right column, p. 2, lower right column to p. 3, upper left column | 15-19 |
| A | | 1-14 |
| A | JP 7-033532 A (HITACHI LTD) 03 February 1995 (1995-02-03) entire text | 1-19 |
| A | JP 2-296771 A (ISUZU CERAMICS KENKYUSHO KK) 07 December 1990 (1990-12-07) entire text | 1-19 |
| A | JP 2008-024579 A (NATIONAL INSTITUTE OF ADVANCED INDUSTRIAL & TECHNOLOGY) 07 February 2008 (2008-02-07) entire text | 1-19 |

☑ Further documents are listed in the continuation of Box C.     ☑ See patent family annex.

| | |
|---|---|
| *    Special categories of cited documents: | "T"    later document published after the international filing date or priority date and not in conflict with the application but cited to understand the principle or theory underlying the invention |
| "A"    document defining the general state of the art which is not considered to be of particular relevance | |
| "E"    earlier application or patent but published on or after the international filing date | "X"    document of particular relevance; the claimed invention cannot be considered novel or cannot be considered to involve an inventive step when the document is taken alone |
| "L"    document which may throw doubts on priority claim(s) or which is cited to establish the publication date of another citation or other special reason (as specified) | "Y"    document of particular relevance; the claimed invention cannot be considered to involve an inventive step when the document is combined with one or more other such documents, such combination being obvious to a person skilled in the art |
| "O"    document referring to an oral disclosure, use, exhibition or other means | |
| "P"    document published prior to the international filing date but later than the priority date claimed | "&"    document member of the same patent family |

| Date of the actual completion of the international search | Date of mailing of the international search report |
|---|---|
| **15 November 2023** | **28 November 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**

International application No.

**PCT/JP2023/031775**

| C. | DOCUMENTS CONSIDERED TO BE RELEVANT | |
|---|---|---|
| Category* | Citation of document, with indication, where appropriate, of the relevant passages | Relevant to claim No. |
| A | JP 59-199582 A (MITSUBISHI METAL CORP) 12 November 1984 (1984-11-12)<br>entire text | 1-19 |

Form PCT/ISA/210 (second sheet) (January 2015)

**INTERNATIONAL SEARCH REPORT**

International application No.

**PCT/JP2023/031775**

| Box No. III | Observations where unity of invention is lacking (Continuation of item 3 of first sheet) |
|---|---|

This International Searching Authority found multiple inventions in this international application, as follows:

Document 1: JP 5062402 B2 (NATIONAL INSTITUTE OF ADVANCED INDUSTRIAL & TECHNOLOGY) 31 October 2012 (2012-10-31), claims, etc.

Claims are classified into the two inventions below.
(Invention 1) Claims 1-14
Claims 1-14 have the special technical feature of a "silicon nitride sintered body containing zirconium in an amount of 0.1-10 mass% in terms of oxide, wherein, when in XRD analysis (2θ) of any cross section, the strongest peak strength detected at 35.3°±0.2° on the basis of α-type silicon nitride crystal particles is I35.3, the strongest peak detected at 27.0°±0.2° on the basis of β-type silicon nitride crystal particles is I27.0, and the strongest peak at 33.9° ±0.2° on the basis of zirconium nitride is I33.9, 0.01 ≤ I35.3/I27.0 ≤ 0.5 and 0 ≤ I33.9/I27.0 ≤ 1.0 are satisfied," and are thus classified as invention 1.

(Invention 2) Claims 15-19
Claims 15-19 share the common technical feature of a "silicon nitride sintered body containing zirconium" with claim 1 classified as invention 1. However, said technical feature does not make a contribution over the prior art in light of the disclosure (in particular, see claims) of document 1, and thus cannot be said to be a special technical feature. In addition, there are no other identical or corresponding special technical features between claims 15-19 and claim 1.
In addition, claims 15-19 are not dependent on claim 1. In addition, claims 15-19 are not substantially identical to or similarly closely related to any of the claims classified as invention 1.
Therefore, claims 15-19 cannot be classified as invention 1.
In addition, claims 15-19 have the special technical feature of a "method for producing a silicon nitride sintered body, the method comprising: a step for preparing a molded body by mixing and molding a silicon nitride powder and at least a zirconium compound powder; a step for degreasing the molded body to prepare a degreased body; a step for disposing the degreased body in a sintering chamber; a step for disposing stuffing powder in the sintering chamber; and a sintering step for sintering the degreased body at less than 1650 °C in the sintering chamber in which the stuffing powder is disposed," and are thus classified as invention 2.

1. [✓] As all required additional search fees were timely paid by the applicant, this international search report covers all searchable claims.

2. [ ] As all searchable claims could be searched without effort justifying additional fees, this Authority did not invite payment of additional fees.

3. [ ] As only some of the required additional search fees were timely paid by the applicant, this international search report covers only those claims for which fees were paid, specifically claims Nos.:

4. [ ] No required additional search fees were timely paid by the applicant. Consequently, this international search report is restricted to the invention first mentioned in the claims; it is covered by claims Nos.:

**Remark on Protest**
[ ] The additional search fees were accompanied by the applicant's protest and, where applicable, the payment of a protest fee.

[ ] The additional search fees were accompanied by the applicant's protest but the applicable protest fee was not paid within the time limit specified in the invitation.

[✓] No protest accompanied the payment of additional search fees.

Form PCT/ISA/210 (continuation of first sheet) (January 2015)

**INTERNATIONAL SEARCH REPORT**
Information on patent family members

International application No.

**PCT/JP2023/031775**

| Patent document cited in search report | | | Publication date (day/month/year) | Patent family member(s) | | | Publication date (day/month/year) |
|---|---|---|---|---|---|---|---|
| JP | 2002-284586 | A | 03 October 2002 | US | 2003/0186801 | A1 | |
| | | | | paragraphs [0053], [0054], table 1, example 3 | | | |
| | | | | WO | 02/076908 | A1 | |
| | | | | EP | 1298110 | A1 | |
| JP | 54-148010 | A | 19 November 1979 | US | 4351787 | A | |
| | | | | columns 1-2 | | | |
| JP | 7-033532 | A | 03 February 1995 | (Family: none) | | | |
| JP | 2-296771 | A | 07 December 1990 | US | 5168080 | A | |
| | | | | entire text | | | |
| | | | | EP | 397520 | A1 | |
| JP | 2008-024579 | A | 07 February 2008 | (Family: none) | | | |
| JP | 59-199582 | A | 12 November 1984 | (Family: none) | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2020121752 A
- WO 2020044974 A
- JP 5811391 B
- JP 5062402 B
- JP 2020121752 A
- JP 2020044974 A